Europäisches Patentamt

(19) European Patent Office

Office européen des brevets

(11) Publication number: **0 089 221**

**A1**

(12) # EUROPEAN PATENT APPLICATION

(21) Application number: 83301403.8

(22) Date of filing: 15.03.83

(51) Int. Cl.³: **H 05 K 3/18**
G 03 G 13/00, C 23 C 3/00
H 01 L 21/308, H 01 L 27/00

(30) Priority: 15.03.82 US 357931
02.04.82 US 364838

(43) Date of publication of application:
21.09.83 Bulletin 83/38

(84) Designated Contracting States:
DE FR GB NL

(71) Applicant: EASTMAN KODAK COMPANY
Patent Department 343 State Street
Rochester, New York 14650(US)

(72) Inventor: Kan, Hsin-Chia
28 Bent Oak Trail
Fairport New York 14450(US)

(72) Inventor: McCabe, John Murray
6 Cavan Way
Pittsford New York 14534(US)

(74) Representative: Pepper, John Herbert et al,
KODAK LIMITED Patent Department P.O. Box 114 190
High Holborn
London WC1V 7EA(GB)

(54) Electrographic method of forming conductive circuit patterns and circuit boards formed thereby.

(57) An electrographic method of forming conductive circuits on a circuit board substrate (2) comprises the formation of an electrostatic charge pattern of the circuit followed by development of the charge pattern with an electrographic toner (5) such as a thermosetting polymeric toner, electroless plating catalyst particles (6) are then adhered to the toner pattern and the substrate is immersed in an electroless plating bath to deposit conductive material (3) on the toner pattern.

In one embodiment, the electrostatic charge extends onto the walls of through-holes in the substrate which lie within the area of the charge pattern, thus permitting simultaneous development of the charge on the surface of the substrate and on the walls of the through-holes (4). In another embodiment, conductive patterns are formed on both sides of the substrate (a method known as duplexing).

The method provides circuit boards with improved conductive circuits, particularly within through-hole regions of the board.

FIG. 2

## ELECTROGRAPHIC METHOD OF FORMING CONDUCTIVE
## CIRCUIT PATTERNS AND CIRCUIT BOARDS FORMED THEREBY

This invention relates to a method of forming an electrically conductive circuit pattern on a substrate and to circuit boards formed by the method.

Circuit boards are employed in various electrical apparatus as readily replaceable elements. The boards contain electrical components such as resistors, capacitors and the like. A typical board comprises an electrically insulating substrate and a circuit pattern of conductive material (usually a metal such as copper) formed on the substrate. In many instances, circuit patterns appear on both sides of the substrate, with electrical continuity provided between the patterns via conductive material deposited on the walls of holes in the substrate which are referred to in the art as "through-holes".

The conductive circuit pattern can be established by a number of conventional techniques. One involves precoating the entire substrate with copper, printing an etching resist corresponding to the circuit pattern desired on the copper, removing copper by etching in those areas not protected by etching resist and, finally, removing the etching resist to expose the circuit pattern. This process is referred to as "subtractive" and is considered by many to be economically unattractive.

In a second technique, a conductive circuit pattern is formed by electroless plating in the circuit regions only, thus avoiding having to etch away noncircuit copper. This method is referred to as

-2-

"additive" and constitutes the environment for the present invention.

U.S. Patents 3,391,455 (issued July 9, 1968, to H. Hirohata et al) and 3,259,559 (issued July 5, 1966, to F. W. Schneble, Jr. et al) describe electroless plating in the formation of printed circuit boards. Both patents describe printing or painting an adhesive pattern on a circuit board substrate, the adhesive in the pattern containing finely divided catalyst particles which are catalytic to electrolessly deposited copper. The adhesive is then cured and the board contacted with a plating solution to establish the electrically conductive circuit.

Electroless plating of circuit boards by the prior art, however, poses several difficulties. In particular, the catalytic adhesive compositions which are painted or printed on the substrate are often liquid-based and thus require careful viscosity control to avoid unwanted application in noncircuit areas and to provide uniform application in circuit areas. These compositions, moreover, cannot be coated on the walls of through-holes with the same facility as they are printed on the substrate surface. Thus, special steps are taken, such as the application of vacuum or vibration to draw the composition through the through-holes. When such fabrication techniques are employed, the adhesive composition so applied is neither of uniform thickness in the through-holes nor coatable on the walls of through-holes having relatively small diameters (for example, diameters of 3 millimeters or less), the adhesive compositions often plugging the through-holes.

-3-

Accordingly, it would be desirable to prepare circuit patterns by electroless plating wherein adhesive and catalyst particles are applied to the circuit pattern in a minimum number of steps. Furthermore, it would be desirable to apply adhesive to the substrate surface and the walls of through-holes simultaneously.

In accordance with the present invention, a pattern of adhesive is formed on a substrate electrographically, followed by adhering electroless plating catalyst particles to the adhesive. The method is clean and simple, and provides, as desired, uniform application of adhesive simultaneously to the surface of the substrate and to the walls of through-holes, without requiring the use of vacuum or vibration for satisfactory application of adhesive in the through-holes.

The adhesive in the method of the invention is an electrographic polymeric toner which is electrostatically attracted to the charge pattern. The method, therefore, comprises:

a) forming an electrostatic charge pattern on a substrate,

b) developing the charge pattern with the electrographic polymeric toner,

c) causing particles of an electroless plating catalyst to adhere to the toner, and

d) contacting the catalyst-containing toner with an electroless plating bath to form thereon a conductive pattern corresponding to the developed charge pattern.

In a preferred embodiment, the electrostatic charge pattern extends to the opposite surface of the substrate via through-holes.

-4-

Development with the electrographic toner in this embodiment thus provides simultaneous application of toner to the substrate surface and the through-holes. The toner is uniformly distributed on the board surface and on the walls of the through-holes. No additional steps are necessary to ensure that toner does not plug the through-holes.

Thus, by practice of the present invention, printed circuit boards are provided in a minimum number of steps which avoid the difficulties associated with liquid-based adhesives for adhering plating catalyst.

The invention also includes a novel circuit board which can be made by the method of the invention. The circuit board, which comprises a substrate carrying a pattern of conductive material electrolessly deposited on particles of catalyst in a polymer layer, further contains at least one through-hole in the pattern. The walls of the through-hole comprise, in sequence, a layer of catalyst-free polymer, particles of catalyst embedded in and partially exposed from the polymer layer, and a layer of conductive material electrolessly deposited on the exposed portions of the catalyst particles.

Figure 1 of the drawings is a plan view of a circuit board bearing a conductive circuit pattern in accordance with the present invention.

Figure 2 is a sectional view of the circuit board in Figure 1 taken along the line AA'.

Electrographic methods of forming toner images are well-known, as shown, for example, in Chapters XV-XVI, pages 405-450, of Dessauer and Clark, Xerography and Related Processes (Focal Press, 1965). These methods, which are useful in connection with the present invention, entail formation of an electrostatic charge pattern on a substrate and contacting the pattern with an electrostatically attractable toner to form a toner image of the pattern. In the present method, the circuit board serves as substrate. An electrostatic charge pattern is formed, for example, by exposing the substrate to a corona charging device through a mask bearing a desired circuit pattern. As the mask transmits charge only in circuit regions, an electrostatic charge pattern of the desired circuit is formed on the substrate. Because of the nature of the electrical field, the pattern extends onto the walls of any through-holes present in the area of the circuit pattern.

Alternatively, an electrostatic charge pattern is formed on the substrate by means of stylus recording, or by sequentially charging the entire substrate and selectively dissipating the charge until only the desired circuit pattern remains.

The magnitude and polarity of the charge pattern is varied in accordance with the magnitude and polarity of charge on the toner employed, as well as the insulating characteristics of the substrate upon which the charge pattern is established.

The charge pattern on the substrate is developed with an electrographic polymeric toner, forming thereby a toner pattern corresponding to the charge pattern of the desired circuit. Such toners are well-known to the art of electrography and are provided by liquid or dry developers.

Dry developers are preferably employed and comprise electroscopic toner particles alone or in combination with discrete carrier particles. Developers having carriers are referred to as two-component dry developers, while developers composed solely of toner particles are referred to as single-component dry developers. The carrier particles, when employed, are often magnetically attractable to facilitate formation of so-called "magnetic brushes". During use, the toner particles separate from the mixture and attach to the charge pattern.

Liquid developers, on the other hand, are dispersions of toner particles in an electrically insulating carrier liquid. (The use of liquid developers, in this regard, is to be distinguished from the coating of circuit boards with liquid-based adhesives as described in the prior art. In liquid electrographic development, the substrate, although coated with a liquid composition, retains only the toner component of the developer, the toner component electrostatically migrating from the liquid and adhering to the substrate only in areas of the charge pattern.)

The toner particles comprise polymeric materials which triboelectrically acquire a charge of such magnitude and polarity as to adhere to an electrostatic charge pattern. For use in the present invention, toner polymers are selected on the further basis of their capability of being rendered adhesive to electroless plating catalyst particles. Thus, thermoplastic polymers which become tacky above their glass transition temperatures and solvent-softenable polymers, as well as heat softenable, thermosetting polymers, are each employable.

As a practical matter, circuit boards prepared in the manner set forth herein are often further subjected to solder baths to establish connection of circuit components inserted in through-holes or applied to the circuit pattern. The temperature of such baths is typically in excess of 240°C. Accordingly, the conductive metal plated on the catalyst-containing toner should remain intact under soldering conditions. This is achieved by the selection of toner polymers whose adhesion to plating catalyst is not significantly diminished at soldering temperatures. For example, in the case of thermoplastic polymers, those materials with Tg's approximately equal to or above the soldering temperature are preferred. Thermosetting polymers, on the other hand, are resistant to soldering temperatures after they have been thermoset. It will be appreciated, of course, that the time of residence of the circuit in a soldering bath is a factor in the selection of heat-resistant toners. Thus, if the residence time is small in comparison with the time required for the toner polymer to become adversely affected under soldering conditions, lesser heat resistance can be tolerated. These factors are considered in selecting a suitable toner polymer for the particular soldering conditions anticipated.

Thermoplastic polymers which are useful in the defined toners include those polymers employed in conventional electrographic development. Preferred thermoplastic polymers include those with Tg's above 200°C so as to provide resistance to the effects of soldering when the latter is employed.

Thermosetting polymers are preferred as toners. Prior to thermosetting these polymers, they are heat-softened so as to permit fixing them to the circuit board after developing the electrostatic charge pattern. While the toner is still soft, catalyst particles are brought into contact with the softened toner and partially embedded therein, followed by heating to a higher temperature to initiate thermosetting cure of the toner.

Typical thermosetting polymers include phenolic-type resins, such as copolymers of phenol, resorcinol, a cresol, or a xylenol with an aldehyde or with furfural. Cross-linked polyesters can also be used.

Epoxy resins are particularly useful, such as the reaction product of epichlorohydrin (1-chloro-2,3-epoxy propane) with bisphenol A (2,2-di(p-hydroxyphenyl)propane).

Although epichlorohydrin is the most common organic epoxide employed in the formation of epoxy resins, other epoxides such as, for example, 1,2,3,4-diepoxy butane can also be used. Similarly, epoxy resins derived from phenols other than bisphenol A are suitable for use. Such resins include, for example, the reaction product of epichlorohydrin with resorcinol, with phenols derived from cashew nut oils, with hydroquinones, with 1,5-dihydroxy naphthalene or 2,2,5,5-tetrabis(4-hydroxy phenyl) hexane. Phenolic intermediates of the resol type, hydrazines and sulfonamides, such as, for example, 2,4-toluene disulfonamide, are also useful for reaction with an organic epoxide to produce epoxy resins suitable for use. Aliphatic epoxy resins are also suitable. Such resins are, for example, the reaction product of epichlorohydrin with glycerol, with ethylene glycol or with pentaerythritol.

Phenolic-type thermosetting resins which are employed as the toner include, for example, copolymers of formaldehyde with p-cresol, p-ethyl phenol, p-tert-butyl phenol, p-tert-amyl phenol, p-tert-octyl phenol, di-isobutyl phenol, or a "bisphenol", such as 4,4-isopropylidene diphenol or 2,2-bis(p-hydroxy phenyl) propane.

Suitable thermosetting polymers include Vedox VP180 (trade mark) toner (a polyurethane polymer marketed by Ferro Corp., Cleveland, Ohio); Vedox KA237 (trade mark for a polyester thermosetting polymer marketed by Ferro Corp.); and Corvel ECA-1555-FC (trade mark for an epoxy polymer from Polymer Corp., Reading, Pennsylvania).

Before the step of electroless plating, particles of electroless plating catalyst are caused to adhere to the surface of the toner pattern. These particles serve as catalytic sites to facilitate the chemical reduction of metal salts by reducing agents in electroless plating baths, as discussed below. When reduced, the metals from the salts deposit on the plating catalyst to form the conductive circuit. In the case of copper as the electrolessly plated metal, the catalyst comprises finely divided particles of metal or metal oxides, such as titanium, aluminum, copper, iron, steel, cobalt, zinc, titanium oxide, copper oxide and mixtures or alloys of such metals and/or metal oxides.

The catalyst particles are caused to adhere to the toner pattern to provide a firm bond during subsequent electroless plating. Preferably, the catalyst is partially embedded in the toner and partially exposed therefrom, a configuration which provides a strong bond while permitting deposition of the conductive material. The partial embedding catalyst in an adhesive layer on a circuit board is disclosed in U.S. Patent 3,391,455.

The size of the catalyst particles and the size of the toner particles are interrelated insofar as smaller catalyst particles generally adhere to small toner particles better than do large catalyst particles. The size of toner particles, moreover, is governed in part by the degree of image resolution desired and smallest dimension of the circuit pattern contemplated. Complex networks of closely spaced circuit lines, on the one hand, may call for small-diameter toners while simpler patterns may permit the use of larger toners. Useful results are achieved with toner particles having a mean diameter from 5 to 40 micrometers, preferably from 10 to 20 micrometers. Toners in these particle-size ranges are employed with catalyst particles having a mean diameter from about 5 to about 80 micrometers, preferably from about 30 to about 60 micrometers.

When the catalyst particles are adhered to the toner, electroless plating can proceed. If the toner polymer is thermosetting, further heating is employed to thermoset the polymer before plating, thereby establishing a stronger bond between catalyst and toner, and ultimately between conductive metal plate and toner.

It is often the practice to treat the catalyst to expose fresh, dirt-free catalyst surface and thereby facilitate the catalysis of subsequent electroless plating. This can be accomplished by treatment with aqueous acids such as aqueous sulfuric acid or aqueous hydrochloric acid prior to plating. Alternatively, the catalyst can be lightly abraded with steel wool, sand paper or other abrasive material. Generally, such treatment, if employed, is carried out after catalyst is adhered to toner.

The electroless plating step practiced in accordance with the present invention comprises contacting the catalyst-containing toner pattern with an electroless plating bath to deposit thereon a conductive material. Electroless plating is also known as autocatalytic plating and has sometimes been called chemical plating. Plating baths are based on the process of catalytic reduction of metal salts. The chemical reducers commonly employed are sodium hypophosphite, formaldehyde, sodium borohydride and aminoboranes. The electroless baths are so formulated that the metal salt and the reducer will react only in the presence of a catalyst.

Representative electroless plating baths for arsenic, chromium, cobalt, cobalt-nickel, copper, gold, iron, nickel or palladium are disclosed in Metal Finishing, 1977, pp. 474-484. Electroless plating baths for depositing copper or other metals such as nickel are also disclosed in U.S. Patents 3,259,559 issued July 5, 1966, to F.W. Schneble, Jr., et al, and 3,391,455, mentioned above.

Preferred plating baths for the present invention are copper baths. A representative copper plating bath comprises copper nitrate, sodium bicarbonate, Rochelle salt, sodium hydroxide and formaldehyde at a pH of about 11.5. The baths disclosed in U.S. Patent 3,259,559 comprise a soluble copper salt (e.g., copper sulfate, cupric chloride, cupric nitrate, copper gluconate, or cupric acetate); a complexing agent for the cupric ions (e.g., Rochelle salts; ethylene diamine tetraacetic acid and its sodium salt; nitrolotriacetic acid and salts thereof; N-hydroxyethylenediamine triacetate; triethanolamine; sugar, including sucrose, dextrose, lactose, levulose or maltose; mannitol; sorbitol, or gluconic acid); an alkali or alkaline earth metal hydroxide, such as sodium or potassium hydroxide; an active reducing agent such as formaldehyde; and a small amount of a complexing agent for cuprous ion, such as cyanide salts, e.g., sodium and potassium cyaninlde, acrylonitrile, lactonitrile, glyconitrile, thiourea, allyl alcohol and ethylene. Preferred for use as the complexing agent for cuprous ion are the cyanide salts, such as sodium and potassium cyanide, acrylonitrile, lactonitrile, and glyconitrile.

Suitable commercially available copper electroless plating baths include Metex Electroless Copper Baths 9027 and 9048 and Metex PTH Electroless Copper Bath 9072 ('Metex' is a trade mark) from MacDermid Incorporated, Waterbury, Connecticut; and Enplate (trade mark) Cu400 from Enthone Incorporated, New Haven, Connecticut.

The electrolessly plated circuit board is readily soldered by dipping in a hot solder bath whereby solder is deposited on the conductive circuit pattern.

Advantageously, the present invention facilitates application of a uniformly thick conductive circuit pattern on the walls of through-holes on substrates. Such through-holes most preferably have diameters of 3 millimeters or smaller, preferably diameters of from about 1 to 2 millimeters.

The electrographic method described herein is further employed to form circuit patterns on one side or two sides of a circuit board, with or without through-holes. Formation of a conductive pattern on two sides of a substrate, referred to as "duplexing", is practiced by the procedure set forth above on one side of the board, and thereafter repeating the procedure for the second side. Alternative methods of duplexing are also contemplated in which the sequence of steps associated with the formation of the pattern on one side of the substrate is interrupted at any point or points by one or more of the steps associated with the opposite side pattern as desired.

Advantageously, one can also duplex by simultaneously establishing an electrostatic charge pattern on both sides of the board, the charge pattern extending through any through-holes as noted above. The steps of charge development, catalyst-adhering, curing and electroless plating are then practiced in sequence as set forth above. Thus, a two-sided circuit board is produced by the same number of steps required to produce a single-sided board.

Circuit board substrates upon which the described circuit patterns of electrolessly plated conductive patterns are formed are, of necessity, electrically insulating on those surfaces intended for carrying the circuit patterns. Useful substrates include synthetic resins, metals, synthetics such as wallboard, masonite board and the like, all as described in U.S. Patent 3,259,559, column 13. In the case of metal blanks, insulating coatings such as an epoxy resin coating can be applied to the surface upon which the circuit patterns will be established.

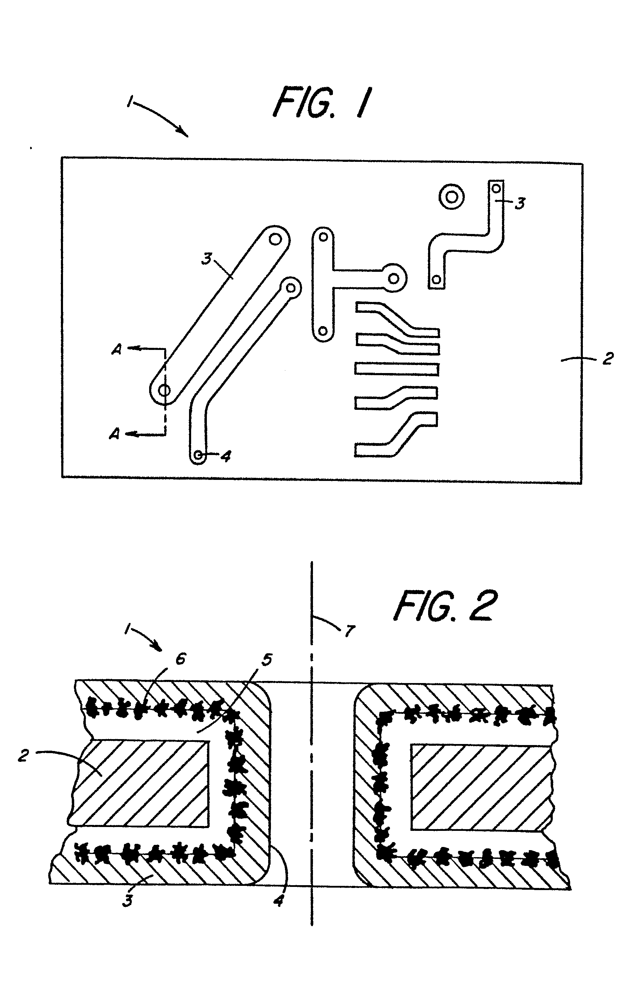

A conductive circuit pattern formed on a substrate and extending onto through-hole walls in accordance with the present invention is illustrated in Figures 1 and 2. Fig. 1 depicts a finished circuit board (1) comprising a substrate (2) carrying a pattern of conductive material (3) including through-holes (4) within the pattern. Referring to Fig. 2, showing a cross-section of one of these through-holes taken along a line (AA), conductive material (3) is deposited indirectly on the walls of through-hole (4). In particular, conductive material (3) within the through-hole is electrolessly deposited on exposed portions of catalyst particles (6) partially embedded within polymeric adhesive layer (5). Polymeric adhesive layer (5) preferably is electrographically formed and fixed directly onto the through-hole walls in accordance with the method of the present invention.

Adhesive layer (5), aside from containing catalyst particles (6) embedded in its surface, is otherwise substantially free from catalyst particles throughout the bulk of its thickness in that portion of the adhesive layer (5) deposited on the through-hole walls. Preferably, catalyst-free adhesive layer (5) extends uniformly and continuously from one surface of substrate (2) to the opposite surface via through-hole (4), forming thereby a duplexed circuit board. In the duplexed mode, moreover, conductive material layer (3) is substantially free from irregularities, such that cross-sections of plated through-hole (4) taken along its cylindrical axis (7) are substantially the same at all points, particularly at the entrances to the through-hole.

The following examples are included to aid in understanding the present invention. In each of the examples, an epoxy-coated aluminum substrate was employed. This substrate was prepared from die-punched aluminum sheeting which had been deburred, chemically cleaned and coated with 3M 5230 (trade mark) epoxy powder in a fluidized bed to a thickness of about 6 mils (150 micrometers). The epoxy powder was cured at 200°C for 5 minutes.

Example 1:

This example illustrates electrographic forming of a printed circuit board using a commercially available two-component, electrographic developer.

An epoxy-coated aluminum plate was charged with a corona charger to -500V through a negative image metal mask and the resultant electrostatic charge pattern was developed with a dry developer containing a toner comprising a carbon black-pigmented cross-linked styrene-acrylic thermoplastic resin. The toner image was fixed on a hot plate at 110°C for 2-3 minutes followed by a dusting thereof with cuprous oxide powder. The toner in turn was fixed again by placing the element on a hot plate at 110°C for 2-3 minutes and all loose metal powder removed. The image-bearing board was then dipped in an acid bath to activate the metal surface, rinsed with water and immersed in a Metex (trade mark) Electroless Copper Bath 9027 for about 1 hour followed by a water rinse. Copper plating resulted on the pattern of fixed toner.

Example 2:

This example illustrates the use of a toner containing a thermoplastic polymer having a higher Tg than the toner polymer of Example 1. A toner polymer having a Tg of 214°C was coarse-ground and then finely ground with a fluid energy mill. The final toner was used with an iron carrier to form a developer at a toner concentration of 3.5%, by weight, with respect to the developer, and its charge was measured to be 50.0μ coul/g.

A charge pattern was established on the metal base plate of Example 1, toned with the above developer with a magnetic brush, and the toner-bearing image fixed at 280°C for 5 minutes. Copper powder having an average particle size of 15-20 micrometers was dusted onto the toner while heating continued for about 1 minute. The board was cooled to room temperature and the copper powder activated by a 1-minute dip treatment in an acid bath (1% HCl solution) followed by 1-hour immersion in a METEX (trade mark) Electroless Copper Bath 9027.

Treatment of the circuit board for 2-10 seconds in a 240°C float solder bath did not affect the adhesion of the toner to the substrate or the copper plate to the toner.

A 90°-bent copper wire was hand-soldered to a 3-mm-diameter dot of plated circuit. The soldered connection withstood up to 1 pound of force applied to the unsoldered end of the copper wire (hereinafter referred to as "the pull-force test").

Example 3:

This example illustrates the formation of a circuit board using a thermosettable polymer toner.

Epoxy-coated aluminum supports were corona-charged through a metal mask and toned with Vedox (trade mark) thermosetting resin, KA 237 (a polyester) and VP 180 (a polyurethane), each available from Ferro Corporation, Cleveland, Ohio. Both resins charged negatively against Hoeganes EH (trade mark) iron carrier. With respect to each toner employed, the toned image was softened (to a tacky state) at 100°C for 2 minutes. The board was then placed on a 150°C hot plate and dusted with steel powder. Curing of the toned image was completed at 200°C for 20 minutes and the surface of the steel powder was activated by an acid bath dip (∿ 30 seconds in 20% HCl solution) followed by an electroless copper treatment for 16 hours in Metex 9017 Electroless Copper Bath". The adhesion of plate to toner and toner to circuit board in a hot, flow solder bath was good. Each plate withstood a pull-force of about 5-. 10 pounds.

Example 4

This example illustrates the production of a two-sided circuit board with "through-the-hole" copper additive plating. The procedure of Example 3 above was used except for the following modifications:

a) the metal imaging mask thickness was reduced from 250 to 125 micrometers (0.010" to 0.005") to improve mask-to-board contact and better resolution;

b) the epoxy-clad boards contained 3 mm through-holes and were imaged using Ferro Corp VP 180 (trade mark) toner fixed at 100°C for 2 minutes; and

c) the second side of the board was imaged, and the toner image fixed at 100°C for 2 minutes. The duplexed board was then immersed in steel powder (average particle size of 50μ) at 150°C, cured at 200°C for 20 minutes, activated for 30 seconds in 20% HCl solution, and copper-plated in a METEX 9027 (trade mark) plating bath for 16 hours.

-18-

The duplexed board was treated successfully in a 240°C float solder bath for 2-10 seconds. Straight copper wires were soldered to the through-hole walls and subjected to a pull-force test. The soldered wire connections withstood up to 20-26 pounds of applied force.

CLAIMS

1.      A method of forming an electrically conductive pattern on a circuit board substrate by applying to the substrate a pattern of an adhesive polymer containing particles of a catalyst for electroless plating and then treating the substrate with an electroless plating bath, characterised in that the pattern of adhesive is formed by (a) producing on the substrate an electrostatic charge pattern,

(b) developing the charge pattern with an electrographic toner containing particles of the adhesive polymer, and

(c) causing particles of the catalyst to adhere to the developed image.

2.      A method according to claim 1 wherein the circuit board substrate comprises at least one through-hole and the electrophotographic formation of the pattern of adhesive results in that pattern, and hence the electrically conductive pattern, extending to the opposite surface of the substrate via each through-hole.

3.      A method according to claim 2 wherein part of the electrostatic charge pattern is on each side of the substrate so that a two-sided circuit board is formed.

4.      A method according to any of the preceding claims wherein the electroless plating bath comprises a copper electroless plating bath.

5.      A method according to any of the preceding claims wherein the catalyst is titanium, aluminium, copper iron, steel, cobalt, zinc, titanium oxide or copper oxide or a mixture or alloy thereof.

6.      A method according to any of the preceding claims wherein the adhesive polymer in the toner is a thermosetting polymer and the developed image is heated after step (c) to thermoset the polymer.

7.        A method according to claim 6 wherein the thermosetting polymer is a phenolic, epoxy or a cross-linked polyester resin.

8.        A method according to any of the preceding claims wherein the particles of the catalyst are caused to adhere to the developed image by heat-softening the toner particles and contacting the catalyst particles with the softened toner so that they are partially embedded therein.

9.        A circuit board comprising a substrate on which an electrically conductive pattern has been formed by a method according to any of claims 1 to 8.

10.       A circuit board which comprises a circuit board substrate having at least one through hole and which carries a pattern of conductive material which extends onto the walls of the through-hole and which is formed by electroless deposition on particles of an electroless plating catalyst in a polymer layer corresponding to said pattern, characterised in that, at least on the walls of the through hole, the particles of the electroless plating catalyst are partially embedded in the surface of a catalyst-free polymer layer.

11.       A circuit board according to claim 10 wherein the pattern of conductive material extends via the walls of the through hole onto both sides of the substrate and is formed by electroless deposition on particles of the electroless plating catalyst partially embedded in the surface of a catalyst-free polymer layer corresponding to said pattern.

0089221

FIG. 1

FIG. 2

European Patent Office

EUROPEAN SEARCH REPORT

## DOCUMENTS CONSIDERED TO BE RELEVANT

EP 83301402.8

| Category | Citation of document with indication where appropriate, of relevant passages | Relevant to claim | CLASSIFICATION OF THE APPLICATION (Int. Cl. ³) |
|---|---|---|---|
| X | <u>DE - B - 1 923 028</u> (XEROX)  * Totality * | 1,6,9 | H 05 K 3/18<br>G 03 G 13/00<br>C 23 C 3/00<br>H 01 L 21/308<br>H 01 L 27/00 |
| A | <u>US - A - 3 779 758</u> (POLICHETTE)  * Claims 1,4 * | 1,7,9 | |
| A | <u>US - A - 4 305 975</u> (JKARI)  * Claims 1,5,6 * | 1,5-7 9 | |

| TECHNICAL FIELDS SEARCHED (Int. Cl. ³) |
|---|
| C 23 C |
| G 03 F |
| G 03 G |
| H 05 K |
| H 01 L |
| G 03 C |

The present search report has been drawn up for all claims

| Place of search VIENNA | Date of completion of the search 13-06-1983 | Examiner SALTEN |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 01 82